# FASCICULE DE BREVET EUROPEEN

(11) **EP 0 735 582 B1**
(45) Date de publication et mention de la délivrance du brevet: **06.09.2000**
(21) Numéro de dépôt: 96410031.7
(22) Date de dépôt: 26.03.1996
(51) Int. Cl.: H01L 23/495

(54) **Boîtier de montage d'une puce de circuit intégré**
Packung zur Montage eines IC-Chips
Package for mounting an IC-chip

(30) Priorité: 31.03.1995 FR 9504065
(43) Date de publication de la demande: 02.10.1996
(73) Titulaire: STMicroelectronics S.A., 94250 Gentilly (FR)
(72) Inventeur: Petit, Luc, 38600 Fontaine (FR)
(74) Mandataire: de Beaumont, Michel

(56) Documents cités:
- EP-A- 0 503 072
- EP-A- 0 534 678
- US-A- 5 256 598
- PATENT ABSTRACTS OF JAPAN vol. 018, no. 643 (E-1640), 7 Décembre 1994 & JP-A-06 252330 (DAINIPPON PRINTING CO LTD), 9 Septembre 1994,
- PATENT ABSTRACTS OF JAPAN vol. 017, no. 344 (E-1390), 29 Juin 1993 & JP-A-05 047986 (FUJITSU LTD), 26 Février 1993,
- PATENT ABSTRACTS OF JAPAN vol. 007, no. 178 (E-191), 6 Août 1983 & JP-A-58 082540 (TOKYO SHIBAURA DENKI KK), 18 Mai 1983,

## Description

La présente invention concerne la réalisation d'un boîtier de circuit intégré. Elle s'applique plus particulièrement à la réalisation d'un boîtier de montage d'une puce de circuit intégré à partir d'une grille de connexion définissant des broches de raccordement électrique de plots de la puce vers l'extérieur du boîtier.

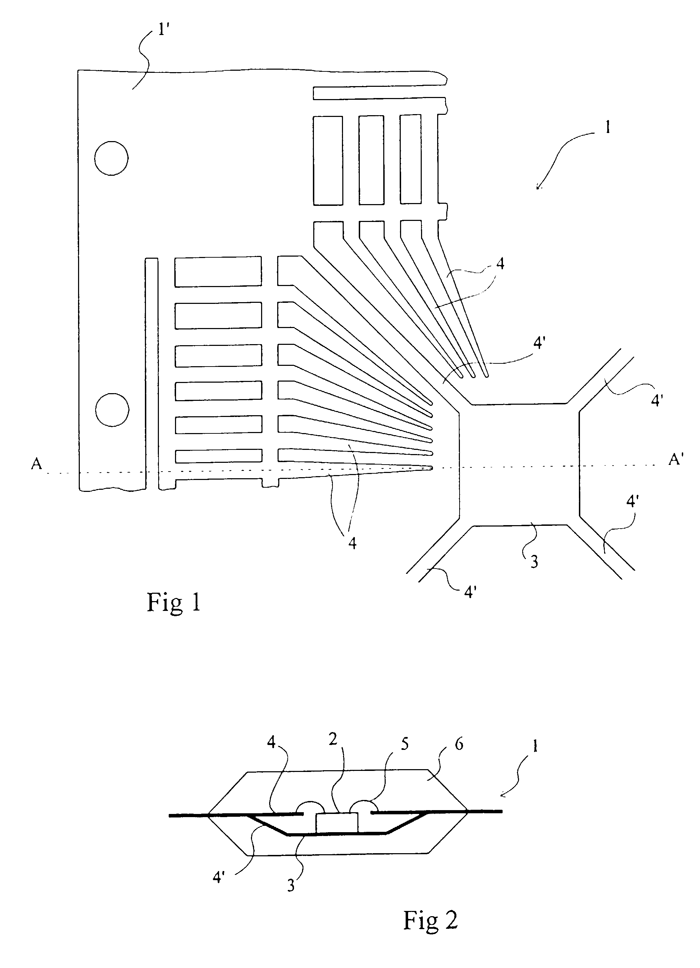

La figure 1 représente partiellement, en vue de dessus, la structure classique d'une grille 1 destinée à permettre les raccordements électriques d'une puce vers l'extérieur d'un boîtier. La figure 2 représente une vue en coupe d'un boîtier de montage d'une puce 2 de circuit intégré à l'aide d'une grille 1 telle que représentée à la figure 1. Le plan de coupe de la figure 2 correspond à la ligne A-A' de la figure 1.

La grille 1 est constituée d'un cadre 1' entourant une plate-forme centrale 3 destinée à supporter la puce 2. Des broches de connexion 4 s'étendent depuis le cadre vers la plate-forme 3 sans atteindre celle-ci. Diverses parties de la grille relient entre elles les broches 4 pour assurer une certaine rigidité au cours du montage. La plate-forme 3 est maintenue par des bretelles 4' s'étendant depuis les coins de la plate-forme vers le cadre 1'. Sur les broches 4, sont soudées des extrémités de fils conducteurs 5 de raccordement de chaque broche 4 à un des plots que comporte la puce 2 sur sa face supérieure. L'ensemble est ensuite encapsulé au moyen d'une résine 6 isolante qui définit l'enveloppe du boîtier. Après encapsulation, on supprime par découpe le cadre 1' et les courts-circuits entre les broches 4. Les fils conducteurs 5 sont généralement des fils d'or. La résine 6 est généralement une résine epoxy et la grille 1 est généralement en cuivre ou en fer-nickel.

La grille 1 est réalisée généralement par poinçonnage mécanique d'une feuille de cuivre. Elle peut parfois être réalisée par découpe chimique (photolithogravure) mais on évite le recours à cette technique pour des fabrications en série car un tel procédé est lent et plus coûteux.

Un inconvénient du poinçonnage mécanique est qu'il nécessite un outil de poinçonnage particulier pour chaque type de puce 2 car les dimensions des plates-formes 3 doivent être adaptées aux dimensions des puces 2 pour limiter la longueur des fils 5. Si le poinçonnage est rapide et apporte donc une bonne productivité, la réalisation de chaque poinçon et de la matrice de l'outil est particulièrement onéreuse.

Dans certaines applications où la puce 2 dissipe une quantité d'énergie importante (typiquement les circuits de puissance), un dissipateur thermique est rapporté en dessous de la plate-forme 3 soit par collage, soit par soudure. Un inconvénient que l'on rencontre dans ce type d'applications est l'empilement d'interfaces thermiques entre la puce et le dissipateur qui nuit à la dissipation de l'énergie.

Pour supprimer ces interfaces thermiques, on a proposé dans le cas des circuits de puissance, de supprimer la plate-forme 3 et de coller la puce 2 directement sur un dissipateur thermique jouant le rôle de plate-forme. Le dissipateur est rapporté sous les broches 4 de la grille 1 par l'intermédiaire d'un isolant disposé en périphérie du dissipateur, en regard des extrémités libres des broches 4 qui sont proximales de ce dissipateur. Un inconvénient d'une telle technique est que la colle nécessaire pour fixer l'isolant sur les broches 4 de la grille 1 peut polluer les connexions électriques entre les doigts 4 et la puce 2, et entraîner des risques de rejet d'un grand nombre de boîtiers lors des procédures de test.

En outre, il y a des cas où la puce 2 doit être isolée électriquement du dissipateur ou de la plate-forme. On dispose alors un isolant sous la puce, ce qui augmente le nombre d'interfaces thermiques. De plus, l'isolant et la colle nécessaire pour sa fixation sont généralement organiques et accumulent de l'humidité. Un excès d'humidité risque de faire fissurer la résine 6 pendant sa polymérisation en étuve ou même ultérieurement lorsque le boîtier est soumis à des températures élevées (soudure à la vague ou soudure en étuve de composants montés en surface).

L'invention vise à réaliser un boîtier comportant un dissipateur thermique qui diminue le nombre d'interfaces thermiques entre la puce et le boîtier tout en réduisant l'humidité accumulée dans le boîtier.

Pour atteindre ces objets, la présente invention utilise un procédé de réalisation de grille de connexion, qui est décrit dans le brevet des Etats-Unis N° 5 256 598. Une grille de connexion unique est prévue pour monter des puces de tailles différentes, cette grille comportant des broches de connexion s'étendant vers une zone centrale de taille aussi petite que possible, voisine de celle de la plus petite puce à monter. On effectue une découpe des broches de connexion autour de la zone centrale aux dimensions de la puce à monter, et on fixe une plate-forme sur la grille.

Selon la présente invention, la plate-forme est en un métal anodisé au moins au niveau de sa périphérie et est d'une taille légèrement supérieure à la taille de ladite découpe. Au moins deux broches formant bretelles sont soudées sur des zones non-anodisées de la plate-forme.

Selon un mode de réalisation de la présente invention, la puce est rapportée sur la plate-forme préalablement à la liaison de la plate-forme à la grille.

Selon un mode de réalisation de la présente invention, la zone centrale est pleine.

La présente invention prévoit également un boîtier de circuit intégré comprenant une grille de connexion munie de broches de connexion s'étendant vers une puce et dont au moins deux broches de part et d'autre de la puce forment des bretelles de support d'une plate-forme sur laquelle est montée la puce. La plate-forme est en un métal anodisé au moins au niveau de sa périphérie sur laquelle reposent les extrémités des broches de connexion, proximales de la puce, lesdites bretelles étant soudées sur des zones non-anodisées de la plate-forme.

Selon un mode de réalisation de la présente invention, la plate-forme constitue un dissipateur thermique.

Selon un mode de réalisation de la présente invention, la plate-forme est dépourvue d'anodisation dans une zone centrale de réception de la puce, ladite zone centrale rejoignant les zones destinées aux bretelles de liaison de la plate-forme à la grille.

Selon un mode de réalisation de la présente invention, la plate-forme comporte un anneau dépourvu d'anodisation, entourant la puce qui repose sur une zone anodisée.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ;
les figures 3A à 3C représentent, en vue de dessus, respectivement un mode de réalisation d'une grille selon l'invention et deux variantes d'un premier mode réalisation d'une plate-forme selon l'invention ;
les figures 4A à 4C représentent, en vue de dessus et en coupe, une première variante d'un second mode de réalisation d'une plate-forme selon l'invention ;
les figures 5A et 5B représentent respectivement en vue de dessus et en coupe une deuxième variante du second mode de réalisation d'une plate-forme selon l'invention ; et
les figures 6A et 6B représentent respectivement en vue de dessus et en coupe une troisième variante du second mode de réalisation d'une plate-forme selon l'invention.

Pour des raisons de clarté, les représentations des figures ne sont pas à l'échelle et les mêmes éléments ont été désignés aux différentes figures par les mêmes références.

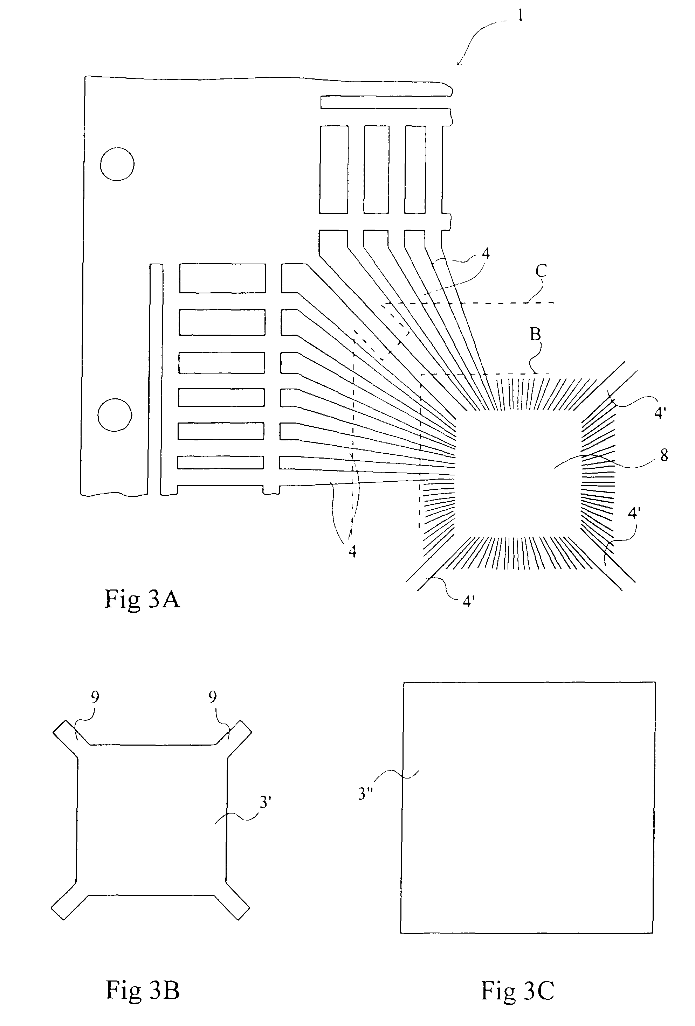

Comme le montre la figure 3A, la présente invention prévoit la réalisation d'une grille 1 aux dimensions extérieures de celle d'une famille de boîtiers et qui comporte des broches de connexion 4 s'étendant vers une zone centrale 8 la plus réduite possible, de préférence aux dimensions de la plus petite puce à monter. En d'autres termes, on réalise au moyen d'un outil de poinçonnage mécanique une grille 1 présentant une zone centrale 8 dont la taille correspond à la limite de faisabilité mécanique pour les extrémités des broches 4 proximales de cette zone centrale 8, si cette zone 8 ne peut pas être aussi petite que la plus petite puce. Cette zone centrale 8 peut être vide, mais elle est de préférence anodisée pour assurer une certaine rigidité de la grille.

La grille 1 est associée lors du montage d'une puce en boîtier à une plate-forme 3' (figure 3B) ou 3" (figure 3C) dont la taille est fonction de la taille de la puce. La plate-forme 3' ou 3" est réalisée séparément de la grille 1. Le centre de la grille 1 est supprimé par découpage en fonction de la taille de la plate-forme 3' ou 3" et donc en fonction de la taille de la puce.

La liaison de la plate-forme 3' ou 3" à la grille 1 est assurée par au moins deux bretelles 4' de la grille 1 dont les extrémités proximales du centre de la grille 1 sont soudées à la plate-forme 3' ou 3". Pour permettre cette liaison, le centre de la grille 1 est découpé selon un motif qui dépend du mode de réalisation et de la forme de la plate-forme.

La figure 3B illustre une première variante d'un premier mode de réalisation selon laquelle la plate-forme 3' comporte quatre pattes 9 en saillie, régulièrement réparties dans le plan de la plate-forme 3'. Ces pattes 9 sont par exemple aux quatre coins de la plate-forme 3', si elle est rectangulaire ou carrée comme cela est représenté à la figure 3B. Pour une telle plate-forme 3', la grille 1 est découpée selon un motif carré légèrement supérieur au motif carré dans lequel s'inscrit la plate-forme 3' sans ses pattes 9. En d'autres termes, le motif de la découpe de la grille 1 présente une forme générale similaire à la forme générale de la plate-forme 3' mais est d'une taille légèrement supérieure pour que les extrémités des broches 4, proximales de la plate-forme 3', ne soient pas en contact avec cette dernière, à l'exception des bretelles 4' auxquelles la plate-forme 3' est soudée par ses pattes. La zone de la grille 1 évidée selon cette variante est représentée par le pointillé B à la figure 3A.

La figure 3C illustre une seconde variante du premier mode de réalisation selon laquelle la plate-forme 3" ne comporte pas de pattes. La grille 1 est toujours découpée selon un motif de taille légèrement supérieure au motif de la plate-forme 3" mais en laissant aux bretelles 4' une longueur supérieure à celle des broches 4 de la grille 1. Ainsi, lors de l'assemblage de la plate-forme 3" à la grille 1, seules les bretelles 4' seront en contact avec la plate-forme 3". La zone de la grille 1 évidée selon cette variante est représentée par le pointillé C à la figure 3A.

La liaison des bretelles 4' avec la plate-forme 3' ou 3" est par exemple effectué par soudure par points au moyen d'un laser.

L'invention permet d'optimiser la rentabilité des outils de poinçonnage des grilles. En effet, un même outil de poinçonnage de grilles est utilisé pour toute une famille de boîtiers comportant des puces de tailles différentes. Seuls des outils de poinçonnage simples, donc peu coûteux, destinés à réaliser la découpe centrale de la grille sont associés à chaque type de puce.

Un avantage de la plate-forme réalisée séparément est qu'elle permet une fixation de la puce à la plate-forme avant qu'elle soit liée à la grille 1. Ceci limite considérablement les risques de détérioration de la grille 1, qui est très fragile en raison de la finesse de ses broches 4, en réduisant considérablement ses manipulations. La grille 1 est ainsi associée à la plate-forme au dernier moment pour la réalisation des connexions des broches 4 aux plots de la puce et l'encapsulation.

En outre, la plate-forme peut être réalisée en un matériau différent de celui de la grille, voire présenter une épaisseur différente de celle de la grille. On peut ainsi, par exemple, choisir pour la plate-forme un matériau (par exemple un alliage de fer et de nickel) dont le coefficient de dilatation est proche de celui du silicium qui constitue la puce. Ceci n'est pas le cas du cuivre généralement utilisé pour la grille pour ses caractéristiques de conductivité électrique. Le fait d'adapter la dilatation de la plate-forme à la dilatation de la puce permet de limiter les risques d'endommagement de la puce qui peuvent se produire lors du séchage de la résine d'encapsulation ou pendant le fonctionnement du circuit dans lequel le boîtier est implanté sous l'effet de variations de température, ou encore lors des opérations de soudure (à la vague, en étuve).

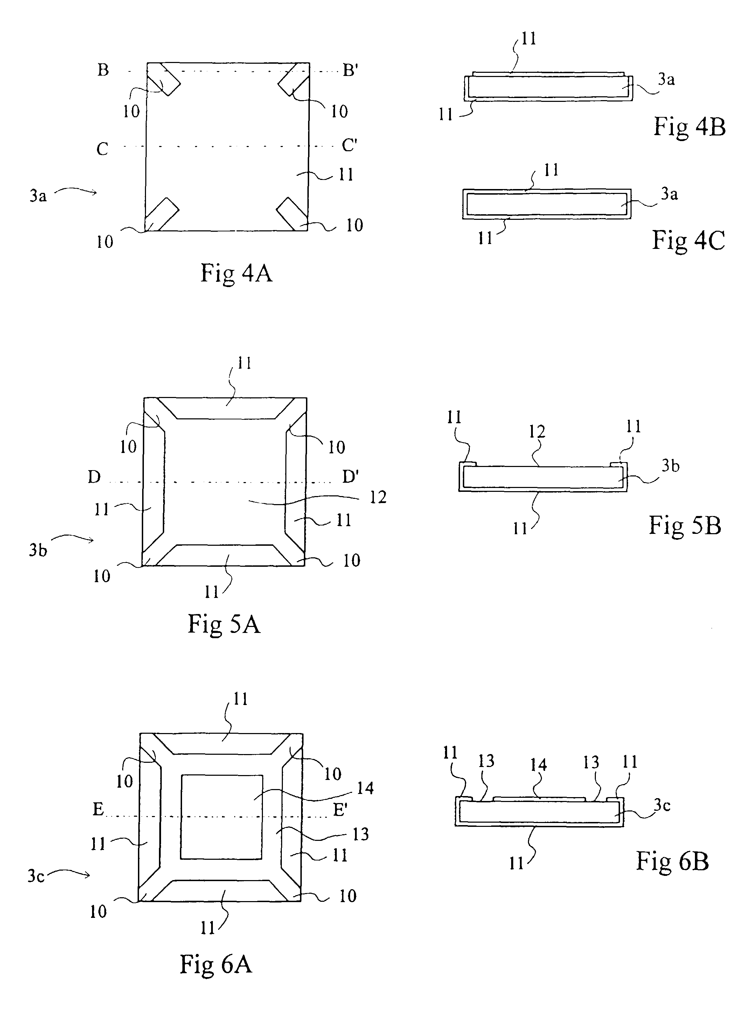

Les figures 4A à 6B illustrent un second mode de réalisation de l'invention dans lequel la plate-forme joue le rôle de dissipateur thermique.

Une plate-forme selon ce mode de réalisation est réalisée en un matériau permettant une forte dissipation thermique qui est partiellement recouvert dans des zones déterminées d'une couche d'isolement. Selon l'invention, ce matériau est de préférence de l'aluminium, anodisé dans des zones déterminées.

Le choix de l'aluminium est motivé par le fait que c'est un excellent conducteur thermique et que la plate-forme en aluminium peut être localement masquée au moyen d'un vernis épargne qui résiste aux acides d'anodisation. Le vernis épargne possède la caractéristique de pouvoir être ensuite éliminé dans une solution faiblement alcaline dans laquelle la couche d'aluminium anodisé présente une inertie chimique de plusieurs minutes. Ce délai est suffisant pour éliminer le vernis épargne. L'épaisseur des zones anodisées est par exemple de l'ordre de 3 à 15 micromètres.

On peut ainsi réaliser différentes variantes de plates-formes selon les zones de surface que l'on souhaite conductrices ou isolantes.

Les figures 4A à 4C illustrent une première variante d'une plate-forme 3a en aluminium anodisé dans des zones déterminées. Les figures 4B et 4C sont respectivement des coupes selon les lignes B-B' et C-C' de la vue de dessus représentée à la figure 4A.

La plate-forme 3a est anodisée sur toutes ses surfaces à l'exception de zones 10 destinées à être soudées sous les bretelles 4' d'une grille. Pour des raisons de clarté, les zones anodisées de la plate-forme 3a ont été représentées sur les vues en coupe par une couche 11. Un tel mode de réalisation simplifie encore l'outillage nécessaire à la découpe centrale de la grille et à la découpe de la plate-forme. En effet, la grille et la plate-forme peuvent désormais être découpées selon des motifs semblables, la découpe centrale de la grille étant d'une taille légèrement inférieure à la taille de la plate-forme 3a. Ainsi, les extrémités de toutes les broches 4, proximales du centre de la grille, reposent sur la plate-forme 3a, mais cela n'est pas gênant dans la mesure où la surface de la plate-forme 3a est anodisée. Une plate-forme 3a telle que représentée aux figures 4A à 4C peut par exemple être utilisée pour recevoir une puce dépourvue de plan de masse en face inférieure.

Les figures 5A et 5B illustrent une deuxième variante d'une plate-forme 3b en aluminium anodisé dans des zones déterminées. La figure 5B est une coupe selon la ligne D-D' de la vue de dessus représentée à la figure 5A.

Comme précédemment, la plate-forme 3b est en aluminium anodisé. Les zones non anodisées comprennent des zones 10 similaires à celles de la figure 4A, mais ces zones 10 rejoignent une zone centrale non anodisée 12. Une plate-forme 3b telle que représentée aux figures 5A et 5B peut par exemple être utilisée pour recevoir une puce pourvue d'un plan de masse en face inférieure. Les connexions électriques du plan de masse avec l'extérieur du boîtier s'effectuent par l'intermédiaire des zones 12 et 10 et des bretelles 4' de la grille.

Les figures 6A et 6B illustrent une troisième variante d'une plate-forme 3c en aluminium anodisé dans des zones déterminées. La figure 6B est une coupe selon la ligne E-E' de la vue de dessus représentée à la figure 6A.

Comme précédemment, la plate-forme 3c est en aluminium anodisé. Les zones non anodisées comprennent des zones 10 similaires à celles de la figure 4A, mais ces zones 10 sont reliées entre elles par un anneau 13 également non anodisé, la partie centrale 14 de la plate-forme étant anodisée. Une plate-forme 3c telle que représentée aux figures 6A et 6B peut par exemple être utilisée pour recevoir une puce dépourvue de plan de masse mais comportant plusieurs plots de masse en face supérieure. Les fils conducteurs de connexion des différents plots de masse sont tous rapportés sur l'anneau 13 et reliés avec l'extérieur du boîtier par l'intermédiaire des zones 10 et des bretelles 4' de la grille 1.

Bien entendu, la présente invention est susceptible de diverses variantes et modifications qui apparaîtront à l'homme de l'art. En particulier, le choix des matériaux constitutifs de la grille et de la plate-forme est fonction de l'application à laquelle est destinée le boîtier. De plus, bien qu'il ait été fait référence à des boîtiers carrés entraînant la réalisation de grilles carrées, l'invention s'applique à toute forme de boîtier. En outre, la grille et la plate-forme pourront avoir des formes distinctes.

## Revendications

1. Procédé de préparation d'une grille de connexion (1) munie d'une plate-forme rapportée pour monter une puce (2), comprenant les étapes suivantes :
- prévoir une grille de connexion unique pour monter des puces de tailles différentes, cette grille comportant des broches de connexion (4) s'étendant vers une zone centrale (8) de taille aussi petite que possible, voisine de celle de la plus petite puce à monter ;
- effectuer une découpe (B, C) des broches de connexion autour de la zone centrale aux dimensions de la puce à monter ; et
- fixer une plate-forme (3', 3", 3a-3c) sur la grille ;
caractérisé en ce que ladite plate-forme (3a-3c) est en un métal anodisé au moins au niveau de sa périphérie et est d'une taille légèrement supérieure à la taille de ladite découpe, au moins deux broches formant des bretelles (4') de part et d'autre de la plate-forme étant soudées sur des zones non-anodisées de la plate-forme.

2. Procédé selon la revendication 1, caractérisé en ce que la puce (2) est rapportée sur la plate-forme (3' ; 3" ; 3a-3c) préalablement à la liaison de la plate-forme à la grille.

3. Procédé selon la revendication 1, caractérisé en ce que la zone centrale (8) est anodisée.

4. Boîtier de circuit intégré comprenant une grille de connexion (1) munie de broches de connexion (4) s'étendant vers une puce (2) et dont au moins deux broches de part et d'autre de la puce forment des bretelles (4') de support d'une plate-forme (3a-3c) sur laquelle est montée la puce, caractérisé en ce que la plate-forme est en un métal anodisé au moins au niveau de sa périphérie sur laquelle reposent les extrémités des broches de connexion, proximales de la puce, lesdites bretelles étant soudées sur des zones non-anodisées de la plate-forme.

5. Boîtier de circuit intégré selon la revendication 4, caractérisé en ce que la plate-forme (3a-3c) constitue un dissipateur thermique.

6. Boîtier de circuit intégré selon la revendication 4, caractérisé en ce que la plate-forme (3b) est dépourvue d'anodisation dans une zone centrale (12) de réception de la puce (2), ladite zone centrale (12) rejoignant les zones (10) destinées aux bretelles (4') de liaison de la plate-forme (3b) à la grille (1).

7. Boîtier de circuit intégré selon la revendication 4, caractérisé en ce que la plate-forme (3c ; 3d) comporte un anneau (13, 13') dépourvu d'anodisation, entourant la puce (2) qui repose sur une zone (14) anodisée.

## Patentansprüche

1. Verfahren zur Herstellung eines Anschlußverbindungs-Gitterrosts bzw. -Rahmens (1), der mit einer darauf angebrachten Plattform zur Montage eines Chips (2) versehen ist, mit den folgenden Verfahrensschritten:
- Schaffung eines einzigen Anschlußverbindungs-Gitterrosts bzw. -Rahmens zur Montage von Chips unterschiedlicher Größen, wobei der Gitterrost bzw. Rahmen Anschlußverbindungs-Lamellen (4) aufweist, welche sich in Richtung zu einer Mittelzone (8) von kleinstmöglicher Größe erstrecken, die in etwa der Größe des kleinsten zu montierenden Chips entspricht;
- Durchführung einer Beschneidung bzw. Stanzung (B, C) der Anschlußverbindungs-Lamellen um die Mittelzone herum auf Abmessungen des zu montierenden Chips; sowie
- Befestigung einer Plattform (3', 3'', 3a-3c) auf dem Gitterrost bzw. Rahmen;
dadurch gekennzeichnet, daß die genannte Plattform (3a-3c) aus einem Metall besteht, das wenigstens entlang seinem Umfang anodisiert ist und eine geringfügig größere Abmessung als die Abmessung der genannten Beschneidung bzw. Stanzung besitzt, wobei wenigstens zwei Anschlußverbindungs-Lamellen Trag- bzw. Halterungsstreifen (4') zu beiden Seiten der Plattform bilden, welche mit nicht-anodisierten Zonen der Plattform verlötet bzw. verschweißt sind.

2. Verfahren nach Anspruch 1,
dadurch gekennzeichnet, daß der Chip (2) auf der Plattform (3'; 3''; 3a-3c) vor deren Verbindung mit dem Gitterrost aufgebracht wird.

3. Verfahren nach Anspruch 1,
dadurch gekennzeichnet, daß die Mittelzone (8) anodisiert wird.

4. Gehäuse für eine integrierte Schaltung mit einem Anschlußverbindungs-Gitterrost bzw. -Rahmen (1) mit Anschlußverbindungs-Lamellen (4), welche sich in Richtung zu einem Chip (2) erstrecken und von welchen wenigstens zwei Lamellen zu beiden Seiten des Chips Trag- bzw. Halterungsstreifen (4') zur Halterung einer Plattform (3a-3c) bilden, auf welcher der Chip montiert ist,
dadurch gekennzeichnet, daß die Plattform aus einem wenigstens entlang seinem Umfang anodisierten Metall besteht, auf welchem die dem Chip benachbarten Enden der Anschlußverbindungs-Lamellen zu liegen kommen, wobei die genannten Halterungs- bzw. Tragstreifen auf den nicht-anodisierten Zonen der Plattform verlötet bzw. verschweißt sind.

5. Gehäuse für eine integrierte Schaltung nach Anspruch 4,
dadurch gekennzeichnet, daß die Plattform (3a-3c) eine Wärmeabführvorrichtung bildet.

6. Gehäuse für eine integrierte Schaltung nach Anspruch 4,
dadurch gekennzeichnet, daß die Plattform (3b) in einem Mittelbereich (12) zur Aufnahme des Chips (2) anodisierungsfrei ist, wobei die genannte Mittelzone (12) die für die Trag- bzw. Halterungsstreifen (4') zur Verbindung der Plattform (3b) mit dem Gitterrost bzw. Rahmen (1) bestimmten Zonen (10) miteinander verbindet.

7. Gehäuse für eine integrierte Schaltung nach Anspruch 4,
dadurch gekennzeichnet, daß die Plattform (3c; 3d) einen anodisierungsfreien Ring (13, 13') aufweist, welcher den auf einer anodisierten Zone (14) ruhenden Chip (2) umgibt.

## Claims

1. A method for realizing a lead frame (1) having a platform fastened thereto for mounting a chip (2), including the following steps:
- providing a single lead frame for mounting chips of various sizes, said frame including connection leads (4) extending toward a central portion (8), which is substantially of the size of the smallest chip to mount;
- cutting (B, C) the connection leads about the central portion to form areas corresponding to the chip to mount; and
- fixing a platform (3', 3", 3a-3c) to the frame;
characterized in that said platform (3a-3c) is made of a metal anodized at least at its periphery and is slightly bigger than said cutting, at least two leads forming support leads (4') on both sides of the platform being soldered on non-anodized portions of the platform.

2. The method of claim 1, characterized in that the chip (2) is fastened to the platform (3', 3"; 3a-3c) before the connection of the platform to the frame.

3. The method of claim 1, characterized in that the central portion (8) is anodized.

4. An integrated circuit casing having a lead frame (1) provided with connection leads (4) extending toward a chip (2) and wherein at least two support leads (4') on both sides of the chip support a platform (3a-3c) on which the chip is mounted, characterized in that the platform is made of a metal anodized at least at its periphery on which lie the ends of the connection leads, close to the chip, said support leads being soldered on non-anodized portions of the platform.

5. The integrated circuit casing of claim 4, characterized in that the platform (3a-3c) constitutes a heat sink.

6. The integrated circuit casing of claim 4, characterized in that the platform (3b) is not anodized in a central portion (12) for receiving the chip (2), said central portion (12) joining the areas (10) for receiving the support leads (4') linking the platform (3b) to the frame (1).

7. The integrated circuit casing of claim 4, characterized in that the platform (3c, 3d) includes a non-anodized ring (13, 13') surrounding the chip (2) that is mounted on an anodized portion (14).
